(19) Europäisches Patentamt
European Patent Office
Office européen des brevets

(11) **EP 4 030 173 A1**

(12) **EUROPÄISCHE PATENTANMELDUNG**

(43) Veröffentlichungstag:
**20.07.2022 Patentblatt 2022/29**

(21) Anmeldenummer: **21151854.3**

(22) Anmeldetag: **15.01.2021**

(51) Internationale Patentklassifikation (IPC):
*G01R 19/25* (2006.01)     *G01R 31/50* (2020.01)
*G01R 31/67* (2020.01)

(52) Gemeinsame Patentklassifikation (CPC):
**G01R 31/50; G01R 19/2513; G01R 31/67**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Amthor, Arvid**
  **98631 Grabfeld OT Nordheim (DE)**
• **Dölle, Oliver**
  **06108 Halle (DE)**
• **Schütz, Thomas**
  **90762 Fürth (DE)**

(54) **PRÜFUNG EINER PARAMETRISIERUNG EINER ODER MEHRERER MESSEINRICHTUNGEN**

(57) Es wird ein Verfahren zur Prüfung einer oder mehrerer Messeinrichtungen n (42) von Betriebsmitteln (43) eines Energiesystems (4) vorgeschlagen, wobei die Messeinrichtungen n (42) einer gemeinsamen Messeinrichtung (41) zugeordnet sind, gekennzeichnet durch wenigstens die folgenden Schritte:

- Erfassen eines Messsignals $P_n(t)$ durch jede der Messeinrichtung n (42);
- Erfassen eines Summensignals $P_{PCC}(t)$ mittels der gemeinsamen Messeinrichtung (41);
- Bereitstellen einer Zielfunktion $Z$, die eine Differenz zwischen dem erfassten Summensignal $P_{PCC}(t)$ und einem modellierten Summensignal $\hat{P}_{PCC}(t)$ bestimmt, wobei
- das modellierte Summensignal $\hat{P}_{PCC}(t)$ mittels der erfassten Messsignale $P_n(t)$ und eines jeweiligen Skalierungsfaktors $S_n$ gebildet wird; und
- Berechnen der Werte der Skalierungsfaktoren $S_n$ mittels einem Extremalisieren der Zielfunktion $Z$; wobei
- das Prüfen dadurch erfolgt, dass ein Fehler einer der Messeinrichtungen $n$ durch ein Abweichen des berechneten Wertes des zugehörigen Skalierungsfaktors $S_n$ von einem für die jeweilige Messeinrichtung $n$ (42) festgelegten Wert ermittelt wird.

Weiterhin betrifft die Erfindung ein Verfahren zur Inbetriebnahme mehrerer Messeinrichtung (42).

EP 4 030 173 A1

**Beschreibung**

Die Erfindung betrifft ein Verfahren gemäß dem Oberbegriff des Patentanspruches 1 sowie ein Verfahren gemäß dem Oberbegriff des Patentanspruches 14.

Energiesysteme mit mehreren Betriebsmitteln, insbesondere mit mehreren multimodalen Erzeugern (Energieerzeuger), Speichern (Energiespeicher) und Lasten (Energieverbraucher), sind typischerweise Individuallösungen, sodass diese wegen ihrer Komplexität und Einzigartigkeit einen signifikanten Inbetriebsetzungsaufwand erfordern.

Im laufenden Betrieb können die einzelnen Betriebsmittel des Energiesystems, beispielsweise Kältemaschinen, Speicher oder Blockheizkraftwerke, durch lokale, heuristische Regeln gesteuert werden. Aufgrund der Komplexität multimodaler Energiesysteme führen derartige, heuristische Betriebsstrategien der einzelnen Betriebsmittel allerdings nicht zu einer optimalen Betriebsführung des Gesamtsystems, das heißt des Energiesystems.

Eine Verwendung eines übergeordneten, modellbasierten Energiemanagementsystems (EMS) ermöglicht eine verbesserte und optimierte Betriebsführung des Energiesystems. Hierbei werden durch ein bezüglich der Betriebsmittel des Energiesystems zentrales EMS optimale Sollwertvorgaben an untergeordnete Basisregelungen übergeben, welche die verfügbaren Betriebsmittel schließlich auf diese Betriebspunkte einregeln.

Zur Sicherstellung eines effizienten und möglichst fehlerfreien Betriebes des Energiesystems sind Rückmeldungen beziehungsweise Informationen über den aktuellen Systemzustand der einzelnen Betriebsmittel an das EMS erforderlich. Diese Informationen, beispielsweise eine aktuell umgesetzte Energie von Energieverbrauchern und/oder Energiewandlungsanlagen, und/oder eine energiesysteminterne gewonnene Energie, beispielsweise mittels einer Photovoltaikanlage, werden typischerweise mittels zugehöriger Sensoren erfasst. Weiterhin sind Eingangsleistungen beziehungsweise Ausgangsleistungen der Betriebsmittel und/oder Energiesystemkomponenten erforderlich, damit eine möglichst genaue Modellierung durch das EMS ermöglicht wird (Parameteridentifikation). Dadurch sind jedoch im Gegensatz zu heuristischen Regelungen mehr Sensoren erforderlich, welche zu einem deutlich höheren Aufwand für die Inbetriebnahme des EMS führen.

Mit anderen Worten müssen die dem EMS zugehörigen Messeinrichtungen, insbesondere Sensoren oder Zähler, installiert und eingebunden werden. Hierbei können Fehler auftreten, da beispielsweise die einzelnen Arbeitsschritte hierzu von verschiedenen Unternehmen durchgeführt werden und typischerweise keine hinreichenden Hilfsmittel für die Überprüfung der Messstellen beziehungsweise Messvorrichtungen vorhanden sind.

Für bereits bestehende Energiesysteme, die beispielsweise mittels einer heuristischen Steuerung/Regelung betrieben werden, werden eine Vielzahl der gegebenenfalls bereits installierten Messvorrichtungen typischerweise nicht benötigt, sodass Fehler bei deren Einbau und/oder Parametrisierung auch über längere Zeiträume unerkannt bleiben können. Werden solche Energiesysteme in ein modellbasiertes EMS eingebunden, führt dies zu einem ineffizienten beziehungsweise fehlerhaften Betrieb, da die Regelung basierend auf falschen an das EMS übermittelten Informationen erfolgt.

Nach dem Stand der Technik obliegt es dem Inbetriebsetzer des EMS die oben genannten Schwierigkeiten manuell zu prüfen und erkannte Fehler gegebenenfalls zu korrigieren. Aufgrund der Vielzahl vorhandener Betriebsmittel innerhalb komplexer Energiesysteme bleiben jedoch hierbei Fehler häufig unerkannt. Dadurch betreibt das EMS das zugehörige Energiesystem nicht optimal.

Der vorliegenden Erfindung liegt die Aufgabe zugrunde, eine verbesserte Prüfung mehrerer Messeinrichtungen eines Energiesystems, insbesondere im Hinblick auf eine EMS basierte Regelung des Energiesystems, bereitzustellen.

Die Aufgabe wird durch ein Verfahren mit den Merkmalen des unabhängigen Patentanspruches 1 sowie durch ein Verfahren mit den Merkmalen des unabhängigen Patentanspruches 14 gelöst. In den abhängigen Patentansprüchen sind vorteilhafte Ausgestaltungen und Weiterbildungen der Erfindung angegeben.

Das erfindungsgemäße Verfahren zur Prüfung einer oder mehrerer Messeinrichtungen $n$ von Betriebsmitteln eines Energiesystems, wobei die Messeinrichtungen $n$ einer gemeinsamen Messeinrichtung zugeordnet sind, ist gekennzeichnet durch wenigstens die folgenden Schritte:

- Erfassen eines Messsignals $P_n(t)$ durch jede der Messeinrichtung $n$;
- Erfassen eines Summensignals $P_{PCC}(t)$ mittels der gemeinsamen Messeinrichtung;
- Bereitstellen einer Zielfunktion $Z$, die eine Differenz zwischen dem erfassten Summensignal $P_{PCC}(t)$ und einem modellierten Summensignal $\hat{P}_{PCC}(t)$ bestimmt, wobei
- das modellierte Summensignal $\hat{P}_{PCC}(t)$ mittels der erfassten Messsignale $P_n(t)$ und eines jeweiligen Skalierungsfaktors $S_n$ gebildet wird; und
- Berechnen der Werte der Skalierungsfaktoren $S_n$ mittels einem Extremalisieren der Zielfunktion $Z$; wobei
- das Prüfen dadurch erfolgt, dass ein Fehler einer der Messeinrichtungen $n$ durch ein Abweichen des berechneten Wertes des zugehörigen Skalierungsfaktors $S_n$ von einem für die jeweilige Messeinrichtung $n$ festgelegten Wert ermittelt wird.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt sein. Hierbei kann das erfindungsgemäße Verfahren durch ein Modul eines Energiemanagementsystems durchgeführt werden. Mit anderen Worten umfasst ein erfindungsgemäßes Energiemanagementsystem ein Modul, welches dazu ausgebildet ist, ein Verfahren gemäß der vorliegenden Erfindung und/oder einer ihrer Ausgestaltungen durchzuführen. Ein erfindungsgemäßes Energiesystems umfasst ein solches erfindungsgemäßes Energiemanagementsystem.

Die Messsignale sowie das Summenmesssignal können jeweils eine bezüglich einer festgelegten Diskretisierung gebildete Zeitreihe sein. Die Diskretisierung kann ein Tag, eine Stunde oder eine Viertelstunde oder ein kürzerer Zeitraum sein.

Der vorliegenden Erfindung liegt ein Energiesystems mit mehreren Betriebsmitteln zugrunde, wobei jedem der $n$ Betriebsmittel eine der Messeinrichtungen zugeordnet ist. Weiterhin sind die Messeinrichtungen der gemeinsamen Messeinrichtung zugeordnet. Beispielsweise wird die Erzeugung und/oder der Verbrauch jedes Betriebsmittels mittels der zum Betriebsmittel zugehörigen Messeinrichtung erfasst. Eine Gesamterzeugung und/oder ein Gesamtverbrauch der Betriebsmittel wird in diesem Ausführungsbeispiel durch die gemeinsame Messeinrichtung erfasst. Allerdings können weitere Messgrößen vorgesehen sein. Weiterhin ist es grundsätzlich nicht erforderlich, dass alle Betriebsmittel des Energiesystems eine zugeordnete Messeinrichtung aufweisen. Die Prüfung gemäß der vorliegenden Erfindung kann sich somit auf ein Teilsystem des Energiesystems beschränken. Hierbei könnte festgelegt werden, beispielsweise durch einen Betreiber des Energiesystems, welche Betriebsmittel beziehungsweise welche Messeinrichtung umfasst sein sollen. Bevorzugt sind jedoch alle Betriebsmittel des Energiesystems, die sich auf das Gewinnen und den Verbrauch von Energie beziehen, bei der erfindungsgemäßen Prüfung umfasst.

Aus struktureller Sicht definiert insbesondere der IPCC Fifth Assessment Report ein Energiesystem als: "Alle Komponenten, die sich auf die Erzeugung, Umwandlung, Lieferung und Nutzung von Energie beziehen." Das Energiesystem ist insbesondere ein Gebäude, beispielsweise ein Bürogebäude und/oder ein Wohngebäude, eine industrielle Anlage, ein Campus, ein Stadtteil, eine Gemeinde und/oder dergleichen.

Das Energiesystem umfasst insbesondere Stromgeneratoren, Kraftwärmekopplungsanlagen, insbesondere Blockheizkraftwerke, Gasboiler, Dieselgeneratoren, Elektrokessel, Wärmepumpen, Kompressionskältemaschinen, Absorptionskältemaschinen, Pumpen, Fernwärmenetzwerke, Energietransferleitungen, Windkrafträder oder Windkraftanlagen, Photovoltaikanlagen, Biomasseanlagen, Biogasanlagen, Müllverbrennungsanlagen, industrielle Anlagen, konventionelle Kraftwerke und/oder dergleichen, als Betriebsmittel.

Fehler im Sinne des erfindungsgemäßen Verfahrens sind insbesondere Fehler, die bei der Installation beziehungsweise beim Einbau der Messeinrichtung, bei der lokalen Einrichtung der Messeinrichtung und/oder bei der Einbindung der Messeinrichtung an das EMS, beispielsweise mittels eines Netzprotokolls, auftreten können. Ein Fehler beim Einbau ist beispielsweise ein Einbau der Messeinrichtung in falscher Richtung. Ein Fehler, der bei der lokalen Einrichtung der Messeinrichtung vorliegen kann, ist eine fehlerhafte Parametrisierung und/oder eine falsche Angabe von technischen Parametern, die für das EMS erforderlich sind, beispielsweise ein Stromwandlerverhältnis und/oder einer spezifischen Wärmekapazität eines zu messenden Fluids. Ein Fehler in der Einbindung der Messeinrichtung kann ein falsch gesetztes Einheitenpräfix und/oder ein falsch gesetztes Vorzeichen bezüglich der Konvention innerhalb des Energiesystems (Gesamtsystem) sein.

Typische Fehler sind unterschiedliche und/oder fehlerhafte Vorzeichen, fehlerhaft beziehungsweise falsch gesetzte Einheitenpräfixe und/oder eine fehlerhafte Angabe von Parametern.

Gemäß der vorliegenden Erfindung wird für jede Messeinrichtung ein Messsignal, beispielsweise ein Leistungsverlauf, erfasst. Unter einem Erfassen wird vorliegend ebenfalls ein Bereitstellen verstanden. Mittels der gemeinsamen Messeinrichtung wird ein Summensignal, beispielsweise ein Gesamtleistungsverlauf Betriebsmittel, beispielsweise an einem Netzanschlusspunkt (engl. Point of Common Coupling; PCC), erfasst. Die jeweiligen Leistungsverläufe können im Hinblick auf Erzeugung und Verbrauch positive und negative Vorzeichen aufweisen.

In einem weiteren Schritt des erfindungsgemäßen Verfahrens wird eine Zielfunktion (engl. objective function, loss function or cost function) für eine mathematische Optimierung, welche typischerweise numerisch erfolgt, bereitgestellt. Hierbei quantifiziert oder modelliert die bereitgestellte Zielfunktion eine Differenz zwischen dem erfassten Summensignal und einem modellierten Summensignal. Das modellierte Summensignal wird mittels der einzelnen Messsignale der Messeinrichtungen und dem Skalierungsfaktor gebildet. Der Skalierungsfaktor modelliert hierbei grundsätzlich Fehler, insbesondere Fehler, die die Parametrisierung der jeweiligen Messeinrichtung betreffen.

In einem weiteren Schritt des erfindungsgemäßen Verfahrens wird der jeweilige Skalierungsfaktor, der mit der jeweiligen Messeinrichtung assoziiert ist, mittels der Optimierung, das heißt mittels einem Extremalisieren der Zielfunktion ermittelt. Mit anderen Worten werden alle Skalierungsfaktoren durch ein Maximieren oder Minimieren der Zielfunktion ermittelt. Da die Zielfunktion die Differenz zwischen dem erfassten Summensignal und dem modellierten Summensignal, das die Skalierungsfaktoren umfasst, bestimmt, ist eine Minimierung der Zielfunktion, das heißt eine Minimierung des betragsmäßigen Fehlers zwischen dem erfassten Summensignal und dem modellierten Summensignal, vorgesehen. Mit anderen Worten werden die Skalierungsfaktoren des modellierten Summensignals derart bestimmt, dass das modellierte Summensignal möglichst genau dem erfassten Summensignal entspricht. Hierbei basiert selbst das modellierte Summensignal auf tatsächlich erfassten beziehungsweise realen Messsignalen, nämlich den Messsignalen der den Betriebsmitteln zugeordneten Messeinrichtungen.

Ein Grundgedanke der vorliegenden Erfindung ist es, eine Optimierung bei der Prüfung zu verwenden. Das ist deshalb der Fall, da alternativ beispielsweise alle Möglichkeiten (Permutationen) von Einheitenpräfixen und Vorzeichen ermittelt werden könnten und jede Permutation einzeln geprüft werden könnte. Dies führt jedoch schnell bei komplexeren Energiesystemen, beispielsweise mit mehr als 20 Betriebsmitteln, zu enormen Rechenzeiten (mehr als 3000 Jahre), die nicht mehr realistisch handhabbar sind. Es ist somit eine Erkenntnis der vorliegenden Erfindung, dass eine Optimierung gemäß der vorliegenden Erfindung ein hinreichend genaues Prüfen in praktikablen Rechenzeiten ermöglicht.

Anschließend wird in einem weiteren Schritt das Prüfen der jeweiligen Messeinrichtung bezüglich eines Installationsfehlers, eines Parametrierungsfehlers und/oder eines Einbindungsfehlers dadurch geführt, dass der mittels der Optimierung ermittelte beziehungsweise berechnete Skalierungsfaktor mit einem für die jeweilige Messeinrichtung festgelegten Wert verglichen wird. Hierbei deutet der für die jeweilige Messeinrichtung festgelegte Wert eine fehlerfreie Messeinrichtung an. Mit anderen Worten wird durch ein Abweichen des ermittelten Skalierungsfaktors von seinem festgelegten Wert ein Fehler, insbesondere ein Installationsfehler, ein Installationsfehler und/oder ein Einbindungsfehler, der Messeinrichtung erkannt. Beispielsweise wird der Wert für eine oder mehrere der Messeinrichtungen, insbesondere für alle der Messeinrichtungen, numerisch durch die Zahl Eins festgelegt. Weist nun der ermittelte beziehungsweise berechnete Skalierungsfaktor für eine der Messeinrichtungen einen von Eins verschiedenen Wert auf, so liegt ein Fehler der Messeinrichtung vor, wobei aus dem zusätzlich aus dem Wert des berechneten Skalierungsfaktors auf die Art des Fehlers geschlossen werden kann. Liegt insbesondere ein Einheitenfehler auf, so kann der berechnete Skalierungsfaktor beispielsweise den Wert 1000 anstatt den Wert 1 aufweisen. Insbesondere weisen die Skalierungsfaktoren somit lediglich diskrete Werte auf.

Durch die vorliegende Erfindung erfolgt somit eine Prüfung einer Mehrzahl von Messeinrichtungen eines Energiesystems, sodass die zugehörigen Messsignale auf Plausibilität überprüft werden können. Durch diese automatisierte Plausibilitätsprüfung reduziert sich der Inbetriebnahmeaufwand im Hinblick von Energiemanagementsystemen deutlich. Fehler, insbesondere Installationsfehlers, eines Parametrierungsfehlers und/oder eines Einbindungsfehlers, können nahezu sicher erkannt werden. Dadurch wird ein effizienter und möglichst optimaler Betrieb des Energiesystems durch das zugehörige Energiemanagementsystem, an welchem die Messeinrichtungen und Betriebsmittel angebunden sind, sichergestellt.

Zusätzlich kann die Art des Fehlers erkannt werden, sodass zugehörige Lösungsmöglichkeiten bereitgestellt werden können. Dadurch kann ein Fehler schnell behoben werden. Weiterhin ermöglicht die vorliegende Erfindung eine vollautomatische Fehlerbehandlung.

Das erfindungsgemäße Verfahren zur Inbetriebnahme mehrerer Messeinrichtungen $n$ von Betriebsmitteln eines Energiesystems, wobei jedem Betriebsmittel eine der Messeinrichtungen $n$ zum Erfassen eines mit seinem Energieverbrauch und/oder seiner Energieerzeugung assoziierten Messsignals $P_n(t)$ zugeordnet ist, und mit einer bezüglich der Messeinrichtungen $n$ gemeinsamen Messeinrichtung, mittels welcher ein bezüglich der Betriebsmittel gemeinsames Messsignal $P_{PCC}(t)$ erfassbar ist, wobei bei der Inbetriebnahme eine Prüfung der Messeinrichtung $n$ bezüglich ihrer jeweiligen Betriebsparameter erfolgt, ist gekennzeichnet dadurch, dass das Prüfen der Messeinrichtungen $n$ gemäß einem der Ansprüche 1 bis 12 durchgeführt wird.

Insbesondere umfasst das Prüfen bevorzugt jeweilige Einheitenpräfixe und/oder Vorzeichen der von den Messeinrichtungen $n$ erfassten Messsignale $P_n(t)$.

Es ergeben sich zum erfindungsgemäßen Verfahren zur Prüfung gleichartige und gleichwertige Vorteile und Ausgestaltungen des erfindungsgemäßen Verfahrens zur Inbetriebnahme.

Gemäß einer vorteilhaften Ausgestaltung der Erfindung wird das modellierte Summensignal $\hat{P}_{PCC}(t)$ mittels $\hat{P}_{PCC}(t) = \sum_n S_n \cdot P_n(t)$ gebildet.

Mit anderen Worten skaliert beziehungsweise gewichtet der erfindungsgemäß vorgesehene Skalierungsfaktor $S_n$ das zugehörige erfasste Messsignal $P_n(t)$ in der Summe der erfassten Messsignale. Im fehlerfreien Fall sollte das erfasste Summensignal der gemeinsamen Messeinrichtung im Rahmen der Messabweichungen mit der Summe der einzelnen Messsignale übereinstimmen. Ein Fehler ist somit durch einen vom Wert 1 verschiedenen Skalierungsfaktor erkennbar.

In einer vorteilhaften Weiterbildung der Erfindung wird der Skalierungsfaktor $S_n$ für jede der Messeinrichtungen $n$ derart ausgebildet, dass dieser einen Wert aus einer mit der jeweiligen Messeinrichtung $n$ assoziierten Menge $\{f(k)\}_{k \in K}$ von Betriebsparametern der Messeinrichtung $n$ aufweist.

Der Skalierungsfaktor einer Messeinrichtung weist somit einen Wert auf, der mit einem möglichen Einbau/Betrieb der Messeinrichtung assoziiert ist. Die Menge $\{f(k)\}_{k \in K}$ beschreibt hierbei somit mögliche Fehler der jeweiligen Messeinrichtung. Beispielsweise ist $f(1) = 1$ und $f(2) = -1$, sodass $\{f(k)\}_{k \in K} = \{-1, 1\}$ ist. In diesem einfachen Beispiel werden somit Vorzeichenfehler der jeweiligen Messeinrichtung modelliert. Somit entspricht die Menge $\{f(k)\}_{k \in K}$ den Betriebsmöglichkeiten der jeweiligen Messeinrichtung, wobei der Begriff der Betriebsmöglichkeiten, durch die genannten Betriebsparameter quantifiziert und durch die Menge $\{f(k)\}_{k \in K}$ mathematisch abgebildet beziehungsweise modelliert werden. Hierbei ist es nicht erforderlich, dass die Menge $\{f(k)\}_{k \in K}$ jede Betriebsmöglichkeit der Messeinrichtung umfasst. Für die vorliegende Ausgestaltung der Erfindung ist es hinreichend, wenn die Menge $\{f(k)\}_{k \in K}$ die wahrscheinlichsten Fehler beziehungsweise Betriebsmöglichkeiten beziehungsweise Betriebsparameter der jeweiligen Messeinrichtung umfasst. Somit kann die Indexmenge $K$ (Teilmenge der natürlichen Zahlen) und somit die Menge $\{f(k)\}_{k \in K}$ grundsätzlich von der Messeinrichtung $n$ abhängig sein. Mit anderen Worten können die Messeinrichtungen verschiedene Betriebsmöglichkeiten/Betriebsparameter aufweisen, die jeweils zu verschiedenen Fehlern führen können. Typische Fehler, die alle Messeinrichtungen aufweisen können und durch dieselbe Menge $\{f(k)\}_{k \in K}$ beschrieben werden können, sind Vorzeichenfehler und Fehler der Einheitenpräfixe. Beispielsweise ist {-1000000,-1000,-1,1,1000,1000000} eine mögliche Menge $\{f(k)\}_{k \in K}$, die bestimmte Einheitenpräfixe, vorliegend Kilo und Mega, mit jeweiligen Vorzeichen $\pm$ für typische Messeinrichtungen (als Permutation) umfasst. Mit anderen Worten ordnet die Funktion $f(k)$ jeder Permutation $k$ von Betriebsparametern einen zugehörigen numerischen Wert zu. Weiterhin ist es nicht erforderlich, dass dieser Wert - wie in dem obenstehend genannten Ausführungsbeispiel ganzzahlig ist. Reellwertige, insbesondere rationale Werte, können vorgesehen sein. Das ist deshalb der Fall, da die Betriebsmöglichkeiten beziehungsweise Betriebsparameter physikalische oder technische Parameter und Größen, die beispielsweise bei der Inbetriebnahme einzustellen sind, mit umfassen können. Beispielsweise umfassen diese eine spezifische Wärmekapazität für ein Fluid und/oder ein Stromwandlerverhältnis. Weitere Permutationsmöglichkeiten, beispielsweise eine Multiplikation mit britischen Maßeinheiten und/oder Skalierungen mit genormten Größen, beispielswiese bei Stromwandlern, können durch $f(k)$ modelliert und $\{f(k)\}_{k \in K}$ berücksichtigt werden.

Gemäß einer vorteilhaften Ausgestaltung der Erfindung umfassen die Betriebsparameter einer Messeinrichtung $n$ einen oder mehrere bei einer Inbetriebnahme der Messeinrichtung $n$ einstellbare Betriebsparameter und/oder einen oder mehrere Installationsparameter der Messeinrichtung $n$.

Insbesondere bei der Inbetriebnahme der Messeinrichtung ist es erforderlich Fehler bezüglich ihres Einbaus, ihrer Parametrisierung und/oder ihrer Einbindung in ein EMS zu ermitteln. Typischerweise werden die jeweiligen Parameter bei der Inbetriebnahme der jeweiligen Messeinrichtung eingestellt. Es ist somit vorteilhaft, diese Möglichkeiten der Inbetriebnahme beim Prüfen auf Fehler gemäß der vorliegenden Erfindung und/oder einer ihrer Ausgestaltungen zu berücksichtigen.

In einer vorteilhaften Weiterbildung der Erfindung umfasst die Menge $\{f(k)\}_{k \in K}$ eine oder mehrere Permutationen von Vorzeichen und Einheitenpräfixen des Messsignals $P_n(t)$ der jeweiligen Messeinrichtung $n$.

Wie bereits obenstehend genannt, sind typische Fehler durch ein falsch festgelegtes Vorzeichen und/oder ein falsch gesetztes beziehungsweise eingestelltes oder festgelegtes Einheitenpräfix (Vorsätze für Maßeinheiten, Einheitenvorsätze). Vorteilhafterweise können solche typischen und häufig auftretenden Fehler durch die Menge $\{f(k)\}_{k \in K}$ dadurch berücksichtigt werden, dass diese die zugehörigen numerischen Werte umfasst. Das ist deshalb der Fall, da der Skalierungsfaktor einer Messeinrichtung Werte innerhalb der Menge $\{f(k)\}_{k \in K}$ annimmt. Somit wird das zur Messeinrichtung zugehörige Messsignal innerhalb des modellierten Summensignals entsprechend skaliert beziehungsweise gewichtet.

Besonders bevorzugt umfasst die Menge $\{f(k)\}_{k \in K}$ wenigstens die Einheitenpräfixe -1, $-10^3$ und $-10^6$ sowie 1, $10^3$ und $10^6$.

Dadurch sind vorteilhafterweise typische Betriebs- beziehungsweise Einstellparameter der jeweiligen Messeinrichtung umfasst, sodass typische beziehungsweise häufige Fehler erkannt beziehungsweise ermittelt werden können.

Gemäß einer vorteilhaften Ausgestaltung der Erfindung umfasst die Menge $\{f(k)\}_{k \in K}$ einen oder mehrere Stromwandler-Faktoren (Stromwandlerverhältnisse) und/oder eine oder mehrere spezifische Wärmekapazitäten.

Dadurch können vorteilhafterweise Messeinrichtungen für Stromwandler und/oder Messeinrichtungen für Fluide, beispielsweise zur Erfassung einer zugehörigen Wärmeleistung, auf Fehler im Sinne der vorliegenden Erfindung überprüft werden.

In einer besonders vorteilhaften Ausgestaltung der Erfindung wird der mit einer der Messeinrichtungen $n$ assoziierte Skalierungsfaktor $S_n$ durch $S_n = \sum_{k \in K} x_n(k) \cdot f(k)$ gebildet, wobei $x_n(k)$ eine Boolesche Auswahlfunktion ist, die jeder Messeinrichtung $n$ genau einen Wert $f(k)$ aus der mit der Messeinrichtung $n$ assoziierten Menge $\{f(k)\}_{k \in K}$ zuordnet.

Dadurch wird ein besonders vorteilhafter Skalierungsfaktor für jede der Messeinrichtungen bereitgestellt. Insbesondere nimmt die vorteilhafte Boolesche Auswahlfunktion lediglich zwei Werte, beispielsweise 0 und 1, an, sodass diese einen Wert der Menge $\{f(k)\}_{k \in K}$ kennzeichnet und in diesem Sinne auswählt. Besonders bevorzugt wird genau ein Wert ausgewählt.

Mit anderen Worten ist es besonders bevorzugt, wenn das Extremalisieren der Zielfunktion unter der Nebenbedingung $\sum_{k \in K} x_n(k) = 1$ mit $x_n(k) \in \{0,1\}$ erfolgt.

Dadurch ist vorteilhafterweise sichergestellt, dass jeder Messeinrichtung beziehungsweise jedem Skalierungsfaktor lediglich ein Wert aus der Menge $\{f(k)\}_{k \in K}$ zugeordnet wird. Dies ist technisch sinnvoll, da eine Messeinrichtung typischerweise keine zwei Vorzeichen und/oder zwei Einheitenpräfixe aufweist. Die vorteilhafte obenstehend genannte Ausgestaltung des Skalierungsfaktors sowie die genannte vorteilhafte Bedingung stellen somit das technische Erfordernis sicher, dass eine Messeinrichtung lediglich in einer Weise installiert beziehungsweise parametrisiert sein kann.

Hierbei ist es besonders bevorzugt, wenn durch das Extremalisieren der Zielfunktion $Z$ die Auswahlfunktionen $x_n(k)$ für alle Messeinrichtungen $n$ bestimmt werden.

Mit anderen Worten wird mittels der Optimierung, das heißt mittels dem Extremalisieren der Zielfunktion, ermittelt, welche Betriebsparameter, beispielsweise im Hinblick von Vorzeichen und/oder Einheitenpräfixe, die jeweilige Messeinrichtung aufweist. Dadurch wird ebenfalls der Wert $f(k)$ aus der Menge $\{f(k)\}_{k \in K}$ ermittelt, sodass dadurch insbesondere festgestellt werden kann, ob ein Fehler bei der jeweiligen Messeinrichtung vorliegt. Weicht der ermittelte Wert $f(k)$ von einem vorgesehenen festgelegten Wert der Messeinrichtung ab, so liegt ein Fehler der Messeinrichtung vor. Beispielsweise sollen die Messwerte der Messeinrichtung nur positiv sein. Wird nun ein negativer Wert von $f(k)$ für diese Messeinrichtung durch die Optimierung ermittelt, so liegt ein Vorzeichenfehler der genannten Messeinrichtung vor. In diesem Ausführungsbeispiel könnte somit die Messeinrichtung in falscher Richtung eingebaut beziehungsweise angeschlossen worden sein.

Gemäß einer vorteilhaften Ausgestaltung der Erfindung wird als Zielfunktion $Z = \sum_{t \in T} |P_{\text{PCC}}(t) - \hat{P}_{\text{PCC}}(t)|$ verwendet.

Mit anderen Worten bemisst die Zielfunktion die betragsmäßige Differenz zwischen dem erfassten Summensignal $P_{\text{PCC}}(t)$ und dem modellierten Summensignal $\hat{P}_{\text{PCC}}(t)$. Das modellierte Summensignal umfasst die Skalierungsfaktoren, mittels welchen mögliche Fehler der jeweiligen Messeinrichtungen bestimmt werden können, sowie die erfassten einzelnen Messsignale. Somit stellt die genannte Zielfunktion technisch sicher, dass die Skalierungsfaktoren beziehungsweise die Auswahlfunktionen derart bestimmt werden, dass der Fehler, das heißt die betragsmäßige Abweichung des zwischen dem erfassten Summensignal und dem modellierten Summensignal möglichst gering ist. Dadurch können die Skalierungsfaktoren beziehungsweise die zugehörigen Auswahlfunktionen vorteilhaft ermittelt werden. Weisen beispielsweise alle Skalierungsfaktoren durch ihre Bestimmung mittels der Optimierung den Wert 1 auf, so sind alle Messeinrichtungen im Rahmen der vorliegenden Prüfung als fehlerfrei zuerkannt.

In einer vorteilhaften Ausgestaltung der Erfindung wird der Betrag der Differenz $|P_{\text{PCC}}(t) - \hat{P}_{\text{PCC}}(t)|$ in der Zielfunktion $Z$ mittels zweier positivwertiger Fehlervariablen $e_{\text{PCC}}^{\pm}(t) \geq 0$ durch $e_{\text{PCC}}^{+}(t) + e_{\text{PCC}}^{-}(t)$ gebildet wird, wobei $P_{\text{PCC}}(t) - \hat{P}_{\text{PCC}}(t) = e_{\text{PCC}}^{+}(t) - e_{\text{PCC}}^{-}(t)$ ist.

Der Betrag (1-Norm) innerhalb der Zielfunktion $Z = \sum_{t \in T} |P_{\text{PCC}}(t) - \hat{P}_{\text{PCC}}(t)|$ ist numerisch, das heißt bei der numerischen Extremisierung der Zielfunktion (Optimierung) nachteilig. Durch die genannten Fehlervariablen, die lediglich positive Werte annehmen (positivwertig) kann die Betragsfunktion für die Numerik vorteilhaft aufgelöst werden. Insbesondere wird dadurch Rechenzeit eingespart. Weitere Zielfunktionen, beispielsweise mittels der 2-Norm gebildete, können vorgesehen sein.

Ergänzend kann das genannte Optimierungsproblem mehrfach hintereinander durchgeführt werden. Mit anderen Worten werden mehrere Lösungen (Werte der Skalierungsfaktoren beziehungsweise der Auswahlfunktionen) berechnet, damit ein Pool an Betriebsparametern, insbesondere an Vorzeichen und/oder Einheitenpräfixen erzeugt werden kann. Hierbei wird als Nebenbedingung der Optimierung verlangt, dass nicht die vorhergehende Lösung vorliegt. Dadurch können vorteilhafterweise der ursprünglichen Lösung nahekommende Lösungen (Nachbarlösungen) ermittelt werden. Das ist immer dann vorteilhaft, wenn verschiedene Kombinationsmöglichkeiten von Betriebsparametern im Wesentlichen zur gleichen Lösung führen, sodass eine weitere Analyse beziehungsweise ein gezieltes Ermitteln erforderlich ist. Dadurch ergibt sich vorteilhafterweise ein vollständigeres Bild, das ein Ermitteln der plausibelsten erscheinenden Lösung ermöglicht.

Eine weitere vorteilhafte ergänzende oder alternative Möglichkeit der Optimierung ist es, falls mehrere gleichberechtigte Lösungen vorliegen, das Optimierungsproblem derart zu formulieren, dass die Anzahl von möglichen Änderungen der aktuellen Konfiguration zu minimieren. Hierbei wird davon ausgegangen, dass wenigstens ein bestimmter Teil der eingestellten Betriebsparameter richtig ist. Hierbei ist zunächst die Zielfunktion durch $\sum_{n=1}^{N} e(n)$ zu bilden und im Rahmen der Optimierung zu minimieren. Hierbei modelliert $e(n)$ die Differenz zu einer aktuellen Konfiguration.

Weiterhin sind die Nebenbedingungen $\sum_{t \in T}\left(e_{PCC}^{+}(t) + e_{PCC}^{-}(t)\right) \leq z$ und $\hat{x}_n(k) - x_n(k) \geq e(n)$ für alle $n, k$ mit $\hat{x}_n(k)$ = 1 erforderlich und zu berücksichtigen. Durch die Nebenbedingung $\sum_{t \in T}\left(e_{PCC}^{+}(t) + e_{PCC}^{-}(t)\right) \leq z$ wird vorteilhafterweise sichergestellt, dass sich der Zielfunktionswert $z$ nicht verschlechtert. Hierbei könnte ebenfalls ein Faktor $\lambda > 1$ mit $\sum_{t \in T}\left(e_{PCC}^{+}(t) + e_{PCC}^{-}(t)\right) \leq \lambda z$ vorgesehen sein. Die weitere Nebenbedingung kennzeichnet die Abweichung zwischen ursprünglicher Parametrisierung (Konfiguration) $\hat{x}_n(k)$ und einer möglichen Lösung $x_n(k)$ des Optimierungsproblems.

Gemäß einer vorteilhaften Ausgestaltung der Erfindung wird als Messeinrichtung $n$ jeweils ein Stromzähler oder ein Wärmezähler verwendet, wobei die Messsignale $P_n(t)$ durch zeitliche Verläufe der jeweiligen Leistungen ausgebildet werden.

Dadurch können vorteilhafterweise typische und bekannte Messeinrichtungen, insbesondere Zähler, mittels der vorliegenden Erfindung und/oder einer ihrer Ausgestaltungen bezüglich ihres Einbaues, ihrer Parametrisierung und/oder ihrer Einbindung in die Regelung des zugehörigen Energiesystems, insbesondere in ein Energiemanagementsystem, geprüft werden.

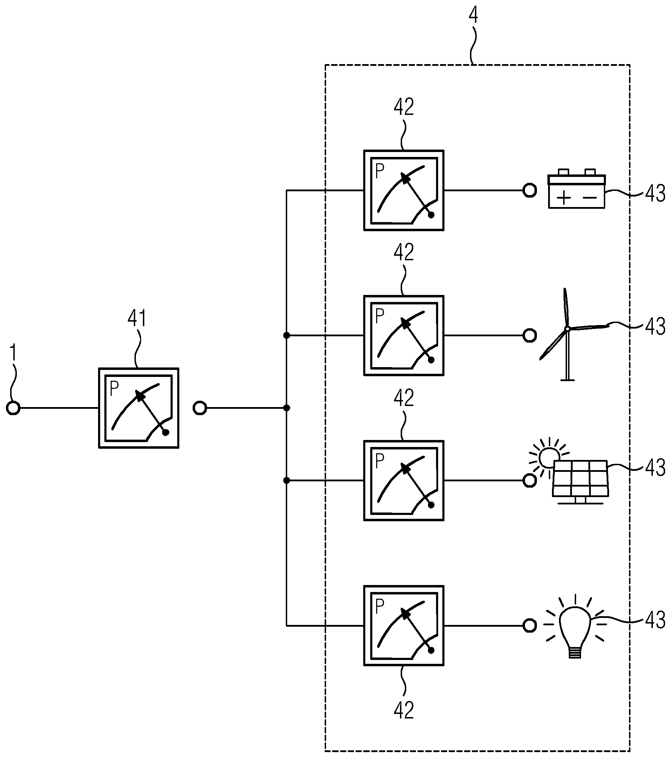

Weitere Vorteile, Merkmale und Einzelheiten der Erfindung ergeben sich aus den im Folgenden beschriebenen Ausführungsbeispielen sowie anhand der Zeichnung. Dabei zeigt die einzige Figur ein schematisiertes Energiesystem mit mehreren Betriebsmitteln.

Gleichartige, gleichwertige oder gleichwirkende Elemente können in einer der Figuren oder in den Figuren mit denselben Bezugszeichen versehen sein.

Die Figur zeigt schematisiert ein Energiesystem 4 mit mehreren Betriebsmitteln 43. Jedem der Betriebsmittel 43 ist eine Messeinrichtung 42 zugeordnet, wobei die jeweilige Messeinrichtung 43 die jeweilige Energiegewinnung und/oder Energieerzeugung, beispielsweise über Leistungsverläufe, in Form eines jeweiligen Messsignals erfasst. Beispielhaft und nicht abschließend weist das Energiesystem 4 als Betriebsmittel 43 einen Batteriespeicher, eine Windkraftanlage, eine Photovoltaikanlage sowie einen Energieverbraucher auf.

Weiterhin ist eine bezüglich der Messeinrichtungen 42 gemeinsame Messeinrichtung 41 vorgesehen. Die gemeinsame Messeinrichtung 41 erfasst, beispielsweise an einem Netzanschlusspunkt 1 des Energiesystems 4, ein gemeinsames Messsignal, beispielsweise eine bezüglich der Betriebsmittel 43 Gesamtenergiegewinnung und/oder Gesamtenergieverbrauch. Das gemeinsame Messsignal kann wiederum in Form eines Leistungsverlaufes vorliegen.

Ist für das dargestellte Energiesystem 4 ein Energiemanagementsystem vorgesehen, so ist es insbesondere bei der Inbetriebnahme des Energiemanagementsystems und/oder bei der Inbetriebnahme der Messeinrichtungen 42 sicherzustellen, dass die richtig eingebaut, parametrisiert und/oder eingebunden sind. Mit anderen Worten ist eine Prüfung der Messeinrichtungen, insbesondere im Hinblick auf ihren technischen Einbau, ihrer technischen Parametrisierung und/oder ihrer technischen Einbindung in das Gesamtsystem beziehungsweise in das Energiemanagementsystem erforderlich.

Eine solche Prüfung wird durch die vorliegende Erfindung und/oder einer ihrer Ausgestaltungen bereitgestellt.

Zur Prüfung der Messeinrichtungen werden einzelne Messsignale $P_n(t)$ der Messeinrichtungen $n$ erfasst und/oder bereitgestellt. Weiterhin wird gemäß dem dargestellten Ausführungsbeispiel ein gemeinsames Messsignal $P_{PCC}(t)$ am Netzanschlusspunkt 1 des Energiesystems 4 erfasst und/oder bereitgestellt. Die Messsignale $P_n(t)$, $P_{PCC}(t)$ sind typischerweise Zeitreihen der jeweiligen am Ort der Messung vorliegenden Leistung, insbesondere einer elektrischen oder thermischen Leistung. Die Messsignale beziehungsweise die Zeitreihen werden über einen Zeitbereich $T$ erfasst. Typischerweise ist hierbei eine zeitliche Auflösung von 15 Minuten vorgesehen, wobei für thermische Lasten aufgrund ihrer Trägheit größere Zeitbereiche vorgesehen sein können. Mit anderen Worten wird der Zeitbereich $T$ bevorzugt in 15 Minutenschritten unterteilt.

In einem weiteren Schritt des Verfahrens wird eine Zielfunktion bereitgestellt, die eine Differenz, insbesondere die betragsmäßige Differenz zwischen dem erfassten Summensignal $P_{PCC}(t)$ und einem modellierten Summensignal $\hat{P}_{PCC}(t)$ bestimmt beziehungsweise modelliert. Das modellierte Summensignal wird im vorliegenden Ausführungsbeispiel mittels der erfassten Messsignale $P_n(t)$ und einem jeweiligen Skalierungsfaktor $S_n$ gebildet. Bevorzugt sind die Skalierungsfaktoren nicht zeitabhängig. Mit anderen Worten ist das modellierte Summensignal von der Kombination $S_n \cdot P_n(t)$ abhängig, das heißt die einzelnen Messsignale $P_n(t)$ werden skaliert. Das ist deshalb von besonderem Vorteil, da dadurch typische Fehler, wie beispielsweise Vorzeichenfehler und/oder Fehler im Einheitenpräfix, die eine Skalierung des jeweiligen Messwertes darstellen, umfasst sind.

Besonders vorteilhafte Skalierungsfaktoren sind durch $S_n = \sum_{k \in K}(x_n(k) \cdot f(k))$ gegeben. Hierbei ist $x_n(k)$ eine Boolesche Auswahlfunktion (oder binäre Entscheidungsvariable), die jeder Messeinrichtung beziehungsweise jedem Skalierungsfaktor genau einem Wert $f(k)$ zuordnet. Diese eindeutige Zuordnung kann durch die Nebenbedingung $1 = \sum_{k \in K} x_n(k)$ sichergestellt werden. Die Funktion $f(k)$ ist ein einer Permutation von Betriebsmöglichkeiten $k$ und somit möglichen Fehlerquellen $k$ zugeordneter numerischer Wert. Beispielsweise weist die Funktion $f(k)$ für Vorzeichen und Einheitenpräfixe die Form $f(-m) = -10^m$ und $f(m) = 10^m$ mit ganzzahligen Werten $m \geq 0$ auf. Werden beispielsweise lediglich die Einheitenpräfixe Kilo und Mega mit ihren jeweiligen Vorzeichen berücksichtigt, so ist $m = 0, 3$ und $6$. Weitere Indizierungen, insbesondere mathematisch äquivalente, können vorgesehen sein.

In einem weiteren Schritt werden die Auswahlfunktionen beziehungsweise die Entscheidungsvariablen $x_n(k)$ mittels einer Minimierung der Zielfunktion, das heißt mittels eines Optimierungsverfahren bestimmt. Dadurch wird für jede der Messeinrichtung 42 genau eine Betriebsmöglichkeit, das heißt vorliegend eine mögliche Kombination von Vorzeichen und Einheitenpräfix zugeordnet. Mit anderen Worten wird für jede Messeinrichtung 42 ihr Vorzeichen und ihr Einheitenpräfix mittels der Optimierung derart bestimmt, dass die betragsmäßige Differenz zwischen dem tatsächlich erfassten Summensignal und dem modellierten Summensignal minimal ist. Weicht die für eine der Messeinrichtungen 42 derart ermittelte Kombination aus Vorzeichen und Einheitenpräfix (Skalierungsfaktor) von einem vorab für diese Messeinrichtung festgelegtes oder vorgesehenes Vorzeichen und Einheitenpräfix (festgelegter oder vorgesehener Skalierungsfaktor) ab, liegt gemäß der vorliegenden Ausgestaltung ein Fehler, beispielsweise beim Einbau, der Parametrisierung und/oder bei der Einbindung, der Messeinrichtung 42 vor.

Das Optimierungsproblem, welches der Prüfung der Messeinrichtungen zugrunde liegt, kann gemäß dem vorliegenden Ausführungsbeispiel folgend durch sieben Gleichungen zusammengefasst werden:

$$\min \sum_{t \in T} \left( e_{\text{PCC}}^{+}(t) + e_{\text{PCC}}^{-}(t) \right) \tag{1}$$

$$P_{\text{PCC}}(t) - \hat{P}_{\text{PCC}}(t) = e_{PCC}^{+}(t) - e_{PCC}^{-}(t) \qquad \forall t \tag{2}$$

$$\hat{P}_{\text{PCC}}(t) = \sum_{n=1}^{N} \hat{P}_n(t) \qquad \forall t \tag{3}$$

$$\hat{P}_n(t) = P_n(t) \cdot \sum_{k \in K} \left( x_n(k) \cdot f(k) \right) \qquad \forall n, t \tag{4}$$

$$1 = \sum_{k \in K} x_n(k) \qquad \forall n \tag{5}$$

$$e_{\text{PCC}}^{+}(t), e_{PCC}^{-}(t) \geq 0 \qquad \forall t \tag{6}$$

$$x_n(k) \in \{0; 1\} \qquad \forall n, k \tag{7}$$

Vorteilhafterweise können durch die vorliegende Prüfung Fehler sowie ihre Art automatisiert erkannt werden. Dadurch wird die Inbetriebnahme der Messeinrichtungen 42 beziehungsweise des zugehörigen Energiesystems beziehungsweise des zugehörigen Energiemanagementsystems deutlich verbessert und vereinfacht.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

Bezugszeichenliste

1      Netzanschlusspunkt
4      Energiesystem
41     gemeinsame Messeinrichtung
42     Messeinrichtung
43     Betriebsmittel

**Patentansprüche**

**1.**  Verfahren zur Prüfung einer oder mehrerer Messeinrichtungen *n* (42) von Betriebsmitteln (43) eines Energiesystems (4), wobei die Messeinrichtungen *n* (42) einer gemeinsamen Messeinrichtung (41) zugeordnet sind, **gekennzeichnet**

**durch** wenigstens die folgenden Schritte:

- Erfassen eines Messsignals $P_n(t)$ durch jede der Messeinrichtung $n$ (42);
- Erfassen eines Summensignals $P_{\text{PCC}}(t)$ mittels der gemeinsamen Messeinrichtung (41);
- Bereitstellen einer Zielfunktion $Z$, die eine Differenz zwischen dem erfassten Summensignal $P_{\text{PCC}}(t)$ und einem modellierten Summensignal $\hat{P}_{\text{PCC}}(t)$ bestimmt, wobei
- das modellierte Summensignal $\hat{P}_{\text{PCC}}(t)$ mittels der erfassten Messsignale $P_n(t)$ und eines jeweiligen Skalierungsfaktors $S_n$ gebildet wird; und
- Berechnen der Werte der Skalierungsfaktoren $S_n$ mittels einem Extremalisieren der Zielfunktion $Z$; wobei
- das Prüfen dadurch erfolgt, dass ein Fehler einer der Messeinrichtungen $n$ durch ein Abweichen des berechneten Wertes des zugehörigen Skalierungsfaktors $S_n$ von einem für die jeweilige Messeinrichtung $n$ (42) festgelegten Wert ermittelt wird.

2. Verfahren gemäß Anspruch 1, **gekennzeichnet dadurch, dass** das modellierte Summensignal $\hat{P}_{\text{PCC}}(t)$ mittels $\hat{P}_{\text{PCC}}(t) = \sum_n S_n \cdot P_n(t)$ gebildet wird.

3. Verfahren gemäß Anspruch 1 oder 2, **gekennzeichnet dadurch, dass** der Skalierungsfaktor $S_n$ für jede der Messeinrichtungen $n$ (42) derart ausgebildet wird, dass dieser einen Wert aus einer mit der jeweiligen Messeinrichtung $n$ (42) assoziierten Menge $\{f(k)\}_{k \in K}$ von Betriebsparametern der Messeinrichtung $n$ (42) aufweist.

4. Verfahren gemäß Anspruch 3, **gekennzeichnet dadurch, dass** die Betriebsparameter einer Messeinrichtung $n$ (42) einen oder mehrere bei einer Inbetriebnahme der Messeinrichtung $n$ (42) einstellbare Betriebsparameter und/oder einen oder mehrere Installationsparameter der Messeinrichtung $n$ (42) umfassen.

5. Verfahren gemäß Anspruch 3 oder 4, **gekennzeichnet dadurch, dass** die Menge $\{f(k)\}_{k \in K}$ eine oder mehrere Permutationen von Vorzeichen und Einheitenpräfixen des Messsignals $P_n(t)$ der jeweiligen Messeinrichtung $n$ (42) umfasst.

6. Verfahren gemäß Anspruch 5, **gekennzeichnet dadurch, dass** die Menge $\{f(k)\}_{k \in K}$ wenigstens die Einheitenpräfixe $-1$, $-10^3$ und $-10^6$ sowie $1$, $10^3$ und $10^6$ umfasst.

7. Verfahren gemäß einem der Ansprüche 3 bis 6, **gekennzeichnet dadurch, dass** die Menge $\{f(k)\}_{k \in K}$ einen oder mehrere Stromwandler-Faktoren und/oder eine oder mehrere spezifische Wärmekapazitäten umfasst.

8. Verfahren gemäß einem der Ansprüche 3 bis 7, **gekennzeichnet dadurch, dass** der mit einer der Messeinrichtungen $n$ (42) assoziierte Skalierungsfaktor $S_n$ durch $S_n = \sum_{k \in K} x_n(k) \cdot f(k)$ gebildet wird, wobei $x_n(k)$ eine Boolesche Auswahlfunktion ist, die jeder Messeinrichtung $n$ (42) genau einen Wert $f(k)$ aus der mit der Messeinrichtung $n$ (42) assoziierten Menge $\{f(k)\}_{k \in K}$ zuordnet.

9. Verfahren gemäß Anspruch 8, **gekennzeichnet dadurch, dass** das Extremalisieren der Zielfunktion unter der Nebenbedingung $\sum_{k \in K} x_n(k) = 1$ mit $x_n(k) \in \{0,1\}$ erfolgt.

10. Verfahren gemäß Anspruch 8 oder 9, **gekennzeichnet dadurch, dass** durch das Extremalisieren der Zielfunktion $Z$ die Auswahlfunktionen $x_n(k)$ für alle Messeinrichtungen $n$ (42) bestimmt werden.

11. Verfahren gemäß einem der vorhergehenden Ansprüche, **gekennzeichnet dadurch, dass** als Zielfunktion $Z = \sum_{t \in T} |P_{\text{PCC}}(t) - \hat{P}_{\text{PCC}}(t)|$ verwendet wird.

12. Verfahren gemäß Anspruch 11, **gekennzeichnet dadurch, dass** der Betrag der Differenz $|P_{\text{PCC}}(t) - \hat{P}_{\text{PCC}}(t)|$ mittels zweier positivwertiger Fehlervariablen $e^{\pm}_{\text{PCC}}(t) \geq 0$ durch $e^{+}_{\text{PCC}}(t) + e^{-}_{\text{PCC}}(t)$ gebildet wird, wobei

$$P_{\text{PCC}}(t) - \hat{P}_{\text{PCC}}(t) = e^{+}_{\text{PCC}}(t) - e^{-}_{\text{PCC}}(t)$$ ist.

13. Verfahren gemäß einem der vorhergehenden Ansprüche, **gekennzeichnet dadurch, dass** als Messeinrichtung $n$ (42) jeweils ein Stromzähler oder ein Wärmezähler verwendet wird, wobei die Messsignale $P_n(t)$ durch zeitliche Verläufe der jeweiligen Leistungen ausgebildet werden.

**14.** Verfahren zur Inbetriebnahme mehrerer Messeinrichtungen $n$ (42) von Betriebsmitteln (43) eines Energiesystems (4), wobei jedem Betriebsmittel (43) eine der Messeinrichtungen $n$ (42) zum Erfassen eines mit seinem Energieverbrauch und/oder seiner Energieerzeugung assoziierten Messsignals $P_n(t)$ zugeordnet ist, und mit einer bezüglich der Messeinrichtungen $n$ (42) gemeinsamen Messeinrichtung (41), mittels welcher ein bezüglich der Betriebsmittel (43) gemeinsames Messsignal $P_{PCC}(t)$ erfassbar ist, wobei bei der Inbetriebnahme eine Prüfung der Messeinrichtung $n$ (42) bezüglich ihrer jeweiligen Betriebsparameter erfolgt, **gekennzeichnet dadurch, dass** das Prüfen der Messeinrichtungen $n$ (42) gemäß einem der Ansprüche 1 bis 12 durchgeführt wird.

**15.** Verfahren gemäß Anspruch 13, **gekennzeichnet dadurch, dass** das Prüfen jeweilige Einheitenpräfixe und/oder Vorzeichen der von den Messeinrichtungen $n$ (42) erfassten Messsignale $P_n(t)$ umfasst.

Europäisches
Patentamt

European
Patent Office

Office européen
des brevets

# EUROPÄISCHER RECHERCHENBERICHT

**Nummer der Anmeldung**

EP 21 15 1854

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2019 207061 A1 (SIEMENS AG [DE]) 19. November 2020 (2020-11-19) * Zusammenfassung * * Absätze [0002] - [0005] * * Absätze [0013] - [0021], [0025], [0030] - [0032] * ----- | 1-15 | INV. G01R19/25 G01R31/50 G01R31/67 |
| A | DE 10 2017 222131 A1 (SIEMENS AG [DE]) 13. Juni 2019 (2019-06-13) * Zusammenfassung * * Absätze [0002], [0008], [0009], [0011], [0016], [0035], [0039], [0040], [0045] * * Absatz [0063] * ----- | 1-15 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 13. August 2021 | Kleiber, Michael |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 21 15 1854

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-08-2021

| Im Recherchenbericht angeführtes Patentdokument | Datum der Veröffentlichung | Mitglied(er) der Patentfamilie | Datum der Veröffentlichung |
|---|---|---|---|
| DE 102019207061 A1 | 19-11-2020 | DE 102019207061 A1<br>WO 2020229050 A1 | 19-11-2020<br>19-11-2020 |
| DE 102017222131 A1 | 13-06-2019 | CN 111465959 A<br>DE 102017222131 A1<br>EP 3685341 A1<br>US 2021165921 A1<br>WO 2019110220 A1 | 28-07-2020<br>13-06-2019<br>29-07-2020<br>03-06-2021<br>13-06-2019 |

EPO FORM P0461

Für nähere Einzelheiten zu diesem Anhang : siehe Amtsblatt des Europäischen Patentamts, Nr.12/82